# EUROPEAN PATENT APPLICATION

(11) **EP 4 624 942 A1**
(43) Date of publication of application: **01.10.2025**
(21) Application number: 25164935.6
(22) Date of filing: 20.03.2025
(51) Int. Cl.: G01R 15/18, H01F 5/00, H01F 27/28

(54) **CURRENT SENSOR**

(30) Priority: 26.03.2024 US 202463570072 P; 12.03.2025 US 202519078072
(71) Applicant: Analog Devices International Unlimited Company, Co. Limerick (IE)
(72) Inventor: HURWITZ, Jonathan Ephraim David, Limerick (IE); MCEVOY, Pierce Michael Anthony, Limerick (IE); HOFFMAN, Brent William, Wilmington, 01887 (US)
(74) Representative: Horler, Philip John

(57) **Abstract**

A current sensor (408) is provided, the current sensor comprising a plurality of substrates (402, 404) that are stacked such that each substrate is rotated with respect to an adjacent substrate of the plurality of substrates. Each substrate comprises a path (302) for a conductor for carrying current to be measured by the current sensor. Each substrate comprises a plurality of measurement coils that progress around the path for the conductor.

## Description

### Technical Field

The present disclosure relates to current sensors, and in particular to current sensors comprising a plurality of substrates.

### Background

Current sensors detect and measure an electrical current passing through a conductor. They are used in many different applications, for example, to provide accurate current measurement in utility meters.

One type of current sensor uses a shunt resistor in series with the current carrying conductor. The voltage drop across the resistor may be measured and, through knowledge of the resistance of the shunt, the current through the resistor may be calculated. However, at higher currents the temperature of the shunt may increase, changing the resistance of the shunt, and therefore providing an inaccurate current measurement. Further, as the shunt is located directly in the measured current path, isolating circuitry may be required between the shunt and the sensitive measurement and processing electronics.

Another type of current sensor uses an electromagnetic transducer to detect changes in a magnetic field generated by the current carrying conductor. These rate-of-change of field current sensors, for example Rogowski coils, do not require any physical connection to the current carrying conductor, and are therefore isolated from the current carrying conductor without the need for any further isolating componentry.

However, as the rate-of-change of field sensor relies on the coupling of magnetic fields, they are susceptible to interference generated by other changing magnetic fields in the vicinity of the sensor. For example, a second current carrying conductor, which is not the target of the measurement operation, may pass near the Rogowski coil. There may be some coupling of the magnetic field generated by this second current carrying conductor into the Rogowski coil, affecting the measurement accuracy of the coil.

A major challenge with Rogowski coils is this sensitivity to electrostatic or capacitive coupling from nearby AC conductors. For example, in a utility meter, electrostatic coupling may be prevalent due to the positioning of the AC bus bar which carries the current to be measured, but also carries the phase voltage which is typically 240V. With electrostatic coupling the voltage on the bus bar couples into the coil through stray capacitance, and because of the high voltage of the conductor only a small stray capacitance can result in an erroneous signal in the sensor.

Rogowski coil or di/dt current sensors that are implemented on a printed circuit board or substrate are often limited to a low number of turns or area enclosed by each turn. This reduces the magnitude of the output of the current sensor. This makes it particularly susceptible to external noise sources such as electrostatic coupling, especially where the measured current is small.

Increasing the loop or turn area improves the smallest signal that can be practically measured, because there is a finite noise in the readout (thermal, flicker, quantisation) electronics and the larger the signal the better the Signal-Noise Ratio (SNR) for a similar electronic cost (power, area, cost). This is particularly important in constrained applications where there is a limit to the size of the coil, or the conductor size or the power consumption of the electronics.

In PCB-implemented current sensors, it is difficult to increase the loop area when the limiting factor is PCB thickness.

There is a need to provide a current sensor implemented on a substrate with an increased induced signal amplitude that offers increased immunity to noise.

### Summary

According to a first aspect, there is provided a current sensor assembly comprising: a stacked plurality of current sensors, each of the plurality of current sensors comprising: a substrate; a path for a conductor carrying current; and a plurality of measurement coils each arranged to progress at least partially around the path for the conductor, wherein the plurality of current sensors are stacked such that, in use, a first signal induced in a first current sensor of the plurality of current sensors by a current in the conductor has a different polarity to a second signal induced in a second current sensor of the plurality of current sensors by the current in the conductor.

According to a second aspect, there is provided a current measurement system, the current measurement system comprising: a current sensor assembly comprising:
a stacked plurality of current sensors, each of the plurality of current sensors comprising: a substrate; a path for a conductor carrying current; and a plurality of measurement coils each arranged to progress at least partially around the path for the conductor, wherein the plurality of current sensors are stacked such that, in use, a first signal induced in a first current sensor of the plurality of current sensors by a current in the conductor has a different polarity to a second signal induced in a second current sensor of the plurality of current sensors by the current in the conductor; a measurement circuit coupled to the current sensor assembly, the measurement circuit configured to receive an output of the current sensor assembly and determine a current in the conductor.

According to a third aspect, there is provided a current sensor assembly comprising:
a stacked plurality of current sensors, each of the plurality of current sensors comprising: a substrate; a path for a conductor carrying current; and a plurality of measurement coils each arranged to progress at least partially around the path for the conductor, wherein each of the plurality of current sensors are substantially identical in design, and each of the plurality of current sensors comprise a first surface and a second surface, wherein a first group of current sensors of the plurality of current sensors are oriented in the stack such that the first surface of each of the first group of current sensors is oriented in a first direction, wherein a second group of current sensors of the plurality of current sensors are oriented in the stack such that the first surface of each of the second group of current sensors is oriented in a second direction, the second direction being opposite to the first direction.

### Brief Description of the Drawings

Aspects of the disclosure will now be described by way of example only and with reference to the accompanying drawings, wherein like reference numerals refer to like parts, and wherein:
Figure 1 is a schematic representation of a Rogowski coil;
Figure 2a is a diagram of a PCB implementation of a rate of change of current sensor;
Figure 2b is a schematic diagram of the rate of change of current sensor of Figure 2a;
Figure 2c is a simplified schematic diagram of the rate of change of current of Figure 2a;
Figure 3a is a substrate comprising a plurality of current measurement coils;
Figure 3b is a rotated view of the substrate comprising a plurality of current measurement coils of Figure 3a;
Figure 3c is a schematic view of the current sensor of Figure 2a in a first orientation;
Figure 3d is a schematic view of the current sensor of Figure 2a in a second orientation;
Figure 4a is current sensor comprising eight stacked substrates;
Figure 4b is current sensor comprising ten stacked substrates;
Figure 5 is a simplified exploded view of the coupling of four substrates in a current sensor;
Figure 6 is a schematic diagram of the four substrate current sensor of Figure 5;
Figure 7 is a simplified exploded view of the coupling of four substrates in a current sensor using castellated vias;
Figure 8a is a simplified exploded view of four substrates in a current sensor with the substrates coupled in an alternative fashion;
Figure 8b is a schematic diagram of the four substrate current sensor of Figure 8a;
Figure 9a is a schematic diagram of a current sensor comprising two half-circle measurement coils;
Figure 9b is a schematic diagram of a current sensor comprising two measurement coils;
Figure 10a is a view of a stack of substrates in a mounting system;
Figure 10b is a view of an alternative stack of substrates in a mounting system;
Figure 11a is a view of a frame or jig for mounting or stacking substrates;
Figure 11b is a view of the frame or jig of Figure 11a including a plurality of substrates;
Figure 11c is a top view of the frame or jig of Figure 11a.

### Detailed Description

Known Rogowski coils may be negatively impacted by both electrostatically and magnetically coupled noise, for example electromagnetic interference noise due to other current carrying conductors being near to the Rogowski coil.

Current sensors implemented on a substrate or printed circuit board (PCB) may include one or more current measurement coils arranged to surround (completely or partially) a conductor under test. The sensitivity of the current measurement coils are defined by the loop area (the area enclosed by each loop of the coil) and the number of loops. When providing a PCB implemented current measurement coil, the coil is limited by the number of layers of the substrate and other manufacturing limitations, such as minimum distance between conductors and minimum sizing requirements for vias. This limits the opportunity to increase the number of loops or turns and the loop area.

To improve upon PCB implemented current sensor sensitivity, two or more current sensors, each comprising substrates and substrate implemented measurement coils, may be stacked or coupled so that all of the substrates surround a conductor under test. This may form a current sensor assembly Each of the current sensors includes two or more current measurement coils surrounding the same path for a current carrying conductor. The current measurement coils included on each of the current sensors may be coupled to one another, and coupled to the measurement circuitry such that the signals add constructively, providing an increased signal output compared to a single substrate alone. This increases the sensitivity of the system, as the current sensor is not limited by the use of a single substrate or current sensor.

The total number of current sensors or PCBs in each current sensor stack may be chosen in dependence on the desired sensitivity of the current sensor. The greater the number of PCBs or current sensors used, the greater the overall sensitivity of the current sensor, allowing it to measure lower currents.

Each of the current sensors in the current sensor assembly may be substantially the same, including the same current measurement coils. As each current sensor or the substrate of each current sensor is the same, increasing the sensitivity of the system may comprise using a greater number of PCBs or substrates, with no further computer aided design or alterations to each individual substrate. This allows the system to be modified on-site, with a site engineer determining only the number of substrates required, rather than having to modify the actual design of the current measurement coil included on the substrate. Further, it results in a system in which only a single substrate or PCB design has to be manufactured.

Alternate current sensors or substrates in the stacks of substrates may be flipped, rotated or provided in a different orientation with respect to an adjacent substrate. The current sensors are stacked such that, in use, a signal induced in a respective current sensor has an inverted polarity to the signal induced in a current sensor adjacent to that respective current sensor in the stack. This stacking arrangement, with adjacent substrates rotated or flipped, results in the measurement coils provided on each substrate of the plurality of substrates having an inverted polarity with regard to its response to the magnetic field created by the conductor under test when compared to the polarity of the measurement coils on an adjacent substrate of the plurality of substrates. By mirroring or flipping each alternate substrate, the interference picked up by connections to terminals on the edges of each substrate cancel. In particular, the interference picked up on each odd-numbered board cancels the interference picked up on each even-numbered board. As a result, the odd and even pairs of boards or substrates together act to positively add the desired electromagnetic field (EMF) from the current carrying conductor while canceling the undesired EMF.

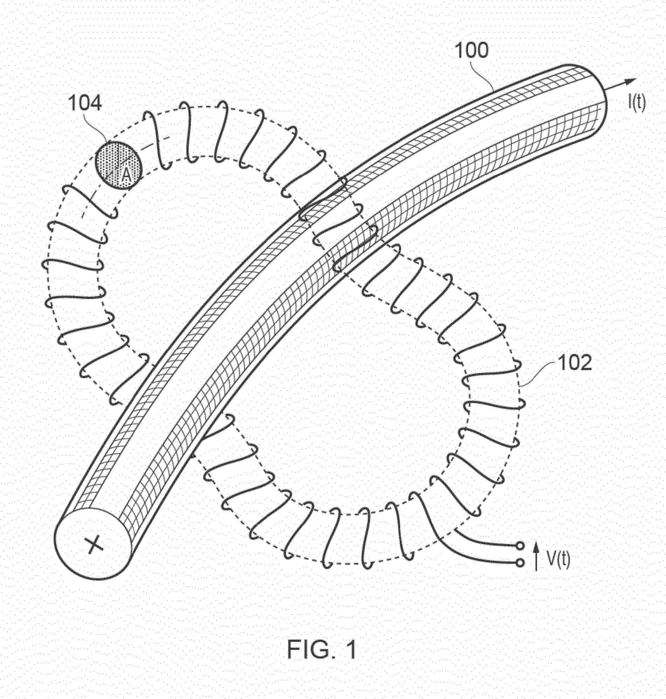

Figure 1 is a diagram of a known Rogowski coil. So as to measure the current I(t) flowing through a current carrying conductor 100, a measurement coil 102 is arranged such that the current carrying conductor 100 passes through the measurement coil. The measurement coil 102 is wound as a helix, such that a loop or turn of the helix encloses a cross sectional area 104, A. The current carrying conductor 100 may be, for example, a bus-bar.

As the current I(t) in the current carrying conductor 100 changes, the field generated by the current also changes. The positioning of the measurement coil causes a voltage to be induced in the measurement coil 102 which is proportional to the rate of change of current, dI/dt. Therefore, integrating the output v(t) of the measurement coil provides a value proportional to the current. Each turn or loop of the coil forms a measurement area 104 in a plane perpendicular to the progression of the current carrying conductor, and the induced voltage is proportional to the area enclosed by the loops or turns.

However, the voltage induced in the measurement coil may be affected by external conductors which the user is not intending to measure.

The Rogowski coil of Figure 1 is a single-ended Rogowski coil, including one measurement coil 102 which progresses around the conductor 100. A current sensor may include more than one measurement coil and be arranged to provide a differential output.

Current sensors may be implemented on a substrate, such as a printed circuit board (PCB). The measurement coil, and the loops of the measurement coils are provided by conductors on two or more layers of the printed circuit board connected by vias between the two or more layers. There are a number of different PCB layouts that may be used in this disclosure.

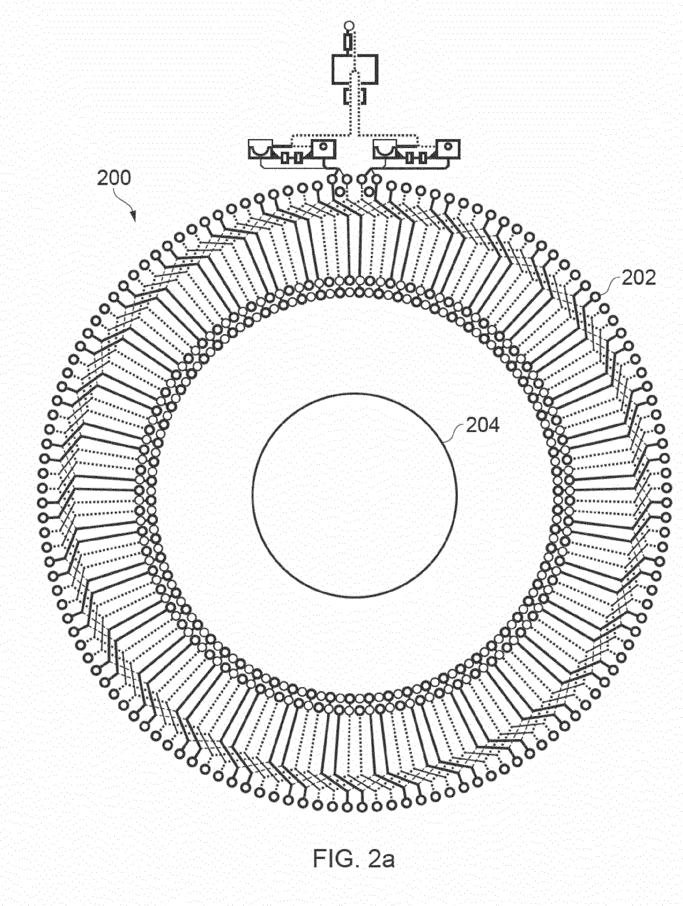

Figure 2a shows one example of a PCB-implemented current sensor 200. The different patterns shown on the current sensor 200 indicate that the conductors or conductive traces are implemented on different layers of the circuit board. By implementing the measurement coils over multiple layers, a coil may be formed, with the area in between the layers contributing to the loop area of the coils. The current sensor shown in Figure 2a includes four measurement coils coupled so as to create a differential output signal.

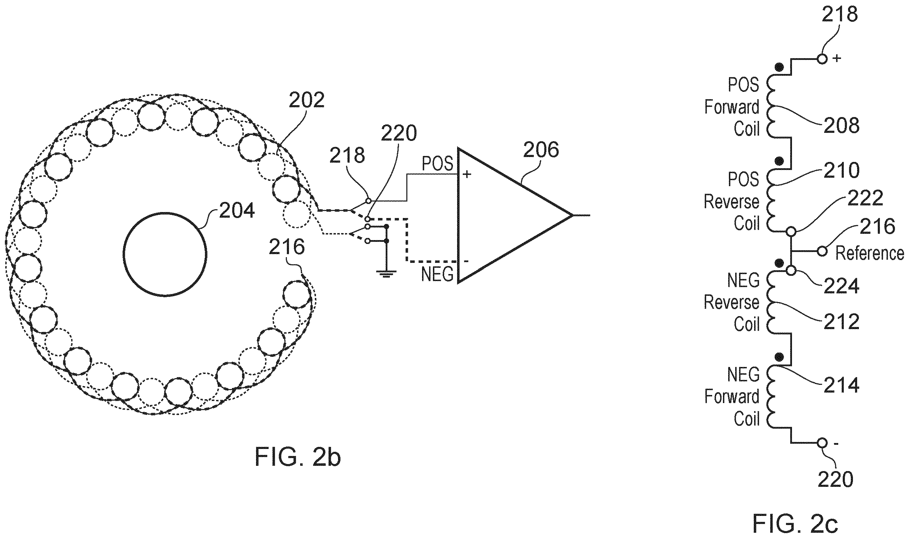

Figure 2b shows an alternative view of the PCB-implemented current sensor 200. The current sensor includes four measurement coils 202 arranged to progress in a circumferential direction around (at least partially) a current carrying conductor 204. As the current sensor is implemented on a printed circuit board or substrate, the circuit board or substrate may include a path or aperture suitable for a current carrying conductor. As such, the measurement coils 202 progress around the path for a current carrying conductor.

The measurement coils 202 are coupled to measurement circuitry 206. The measurement circuit 206 is configured to receive the output of the measurement coils and integrate or otherwise process the output signals to determine the current in the current carrying conductor 204. The measurement circuit 206 may be part of a larger utility meter, power meter or current measurement system. The measurement circuit 206 shown in Figure 2b is a differential amplifier, however the measurement circuit 206 may include any suitable measurement circuitry. For example, the measurement circuit may include an offset generation circuit, an analog or digital integrator configured to integrate the output of the measurement coils so as to determine a measured current, amplification circuitry, amongst other circuitry. The measurement circuit 206 may be a separate system to the current measurement coils and may be provided separately. For example, the measurement circuit 206 may be provided on a separate substrate or as part of a separate device to the measurement coils 202. Alternatively, all or part of the measurement circuit 206 may be provided on the same substrate as the measurement coils 202.

Figure 2c shows a schematic diagram of the PCB implemented current sensor 200. As shown in Figure 2c, the current sensor 200 includes four measurement coils 208-214. The first forward measurement coil 208 is coupled to a first return or reverse measurement coil 210 which progresses around the conductor 204 in an opposite circumferential direction to the first forward measurement coil 208. The second forward measurement coil 214 is coupled to a second return measurement coil 212 which progresses around the conductor 204 in an opposite circumferential direction to the second forward measurement coil 214. Forward and reverse are used here to differentiate between the measurement coils, however it should be understood that all of the coils are measurement coils and contribute to the detection of a current passing through a conductor 204 under test.

A reference node 222 of the first return measurement coil 210 is coupled to a reference node 224 of the second return measurement coil 212 at a terminal 216. The nodes are referred to as reference nodes, as they may be typically coupled to a reference voltage or terminal. However, they may also be referred to simply as nodes or terminals. The terminal or node 216 may be coupled to a reference voltage such as ground or any other suitable reference. Whilst the first return measurement coil 210 and the second return measurement coil 212 are shown as directly coupled in Figure 2C, instead, when part of a larger current measurement system, these return measurement coils may not be directly connected or coupled. The reference node 216 may be provided external to the substrate on which the measurement coils 202 are provided.

The first forward measurement coil 208 is coupled to a first or positive output terminal or node 218 and the second forward measurement coil 214 is coupled to a second or negative output terminal or node 220. As such, the current sensor is a differential current sensor.

The current sensor shown in Figures 2a-2c is one example of a current sensor implemented on a single substrate or printed circuit board (PCB). Current sensors implemented on a substrate or PCB may include different means of coupling the loops of each current measurement coil to one another to form a coil. Other current sensors comprising two or more measurement coils on a single PCB may be provided and used in the following disclosure.

As noted, it is highly desirable to increase the sensitivity of a PCB current sensor. This is particularly important in low current applications which become limited by the signal-to-noise ratio. Increasing the loop area or number of loops in the current sensor provides greater sensitivity. However, increasing the sensitivity of a coil printed on a single PCB is limited by the maximum aspect ratio that can be achieved in current PCB technology. The aspect ratio may refer to the maximum number of turns that can be provided on the substrate, limited by via hole minimum diameter, minimum conductive trace thickness, minimum separation distance between conductive traces, amongst others constraints. Whilst increasing the PCB thickness would increase the loop area of each turn, this often comes at the expense of increasing the via hole size which results in fewer turns.

So as to achieve greater sensitivity, a plurality of individual PCB or substrate implemented current measurement coils may be provided around a single current carrying conductor or path suitable for a current carrying conductor. For example, the two or more substrates may be stacked, layered or grouped on top of one another. Each substrate may comprise a plurality of current measurement coils travelling or progressing around the conductor or path. The current measurement coils distributed across the different substrates may be coupled together, providing a greater number of loops or turns around the current carrying conductor. This helps to overcome the maximum aspect ratio that may be provided by a single PCB implemented current sensor. Stacking, layering or grouping PCBs in this manner may present a number of manufacturing challenges and performance challenges.

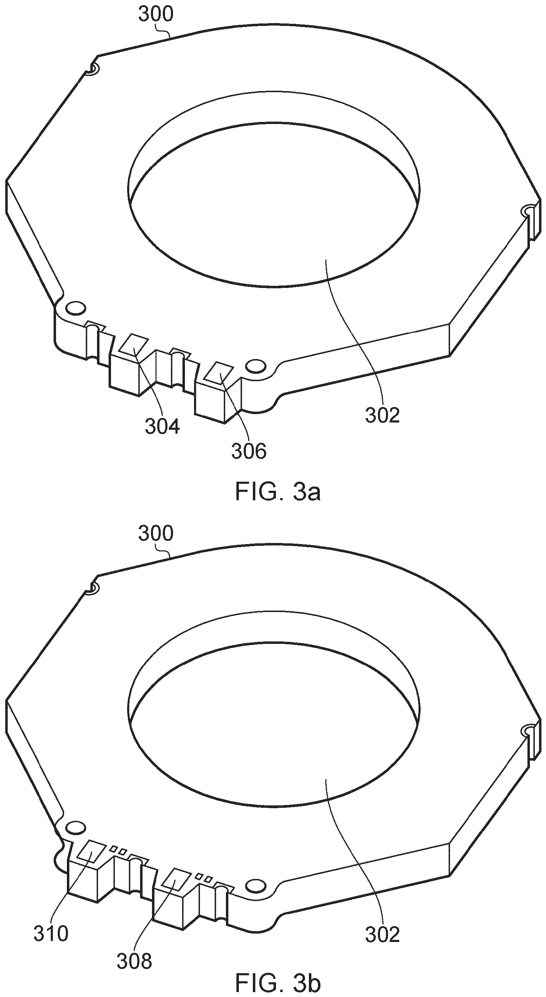

Figure 3a shows a first substrate 300 including a path or aperture 302 suitable for receiving a current carrying conductor. The substrate 300 may also be referred to as a current sensor, as the measurement coils implemented on the substrate act to measure a current. Whilst the substrate shown in Figure 3a includes an aperture, it should be understood that alternatively the current carrying conductor may be provided on the substrate, travelling between the multiple layers of the substrate, as a conductive trace. As such, a path through the substrate may be any suitable aperture or medium through which a conductive trace or conductor suitable for carrying a current under test may pass. The first substrate includes two or more measurement coils (not shown in Figure 3a) implemented across the layers of the substrate, arranged to surround the path 302. The substrate 300 shown in Figure 3a is shown in a first orientation, with a first side or surface of the substrate facing in a first direction (upwards in this case). A second side or surface of the substrate 300 cannot be seen in Figure 3a, as it is an opposite side or surface of the substrate 300 to the first side or surface.

The first substrate 300 includes a first output terminal or node 304 and a second output terminal or node 306 on the first side of the substrate 300. The first output terminal or node 304 may provide a first or positive output and the second output terminal or node 306 may provide a second or negative output (where the coils are differential measurement coils, as described with respect to Figure 2). Where the substrate comprises four measurement coils (for example, arranged in a differential fashion as described with respect to Figure 2c, the first output terminal 304 may correspond to the first positive output terminal 218 and the second output terminal 306 may correspond to the second negative output terminal 220.

Figure 3b shows the first substrate 300 depicted in Figure 3a in a different orientation. The substrate 300 has been rotated or flipped 180 degrees with respect to the orientation in Figure 3a. As such, the second side or surface of the substrate is now visible, and the first side or surface of the substrate is no longer visible.

The substrate 300 shown in the second orientation includes a third 308 and a fourth terminal 310 on the second side of the substrate 300. The third terminal 308 and fourth terminal 310 on the second side of the substrate may be suitable for coupling to a reference terminal. Where the substrate comprises four measurement coils (for example, arranged in a differential fashion as described with respect to Figure 2c), the third terminal or node 308 may correspond to the reference terminal or node 222 and the fourth terminal or node 310 may correspond to the reference terminal or node 224.

Whilst these are separate nodes, they may be typically coupled together to form the differential arrangement of Figure 2c.

As such the substrate 300 includes four terminals 304-310 corresponding to the first output terminal 218 and the second output terminal 220 (+, -, or first and second) and the two terminals 222, 224. The two terminals 222, 224 are coupled to the reference connection in Figure 2C, however as shown in Figures 3a and 3b they may not be connected to one another on the substrate. Alternative numbers of input and output terminals may be provided in dependence on the number of measurement coils implemented on the substrate. The terminals protrude or extend beyond a side or surface of the current sensor 300. This allows them to be easily connected or coupled to other current sensors or measurement circuitry. The terminals may protrude such that, if the current sensor 300 is flipped or rotated, the terminals do not line up with one another. This is because the terminals are off-centre on one side of the current sensor 300.

Apart from the orientation, the substrates 300 depicted in Figures 3a and 3b are the same substrate, such that the current measurement coils on the substrates 300 are identical.

Whilst the substrates 300 may be identical, it should be understood that the substrates may be similar rather than identical. For example, other circuitry, such as measurement circuits 206 may be provided on one or more of the substrates 300. Further, the current measurement coils provided on the substrates may be similar rather than identical. For example, rather than comprising exactly the same measurement coils, the coils of the substrates may have similar number of turns per measurement coil (e.g. within 2%, 5%, or 10% of one another etc) or similar coil layouts to one another.

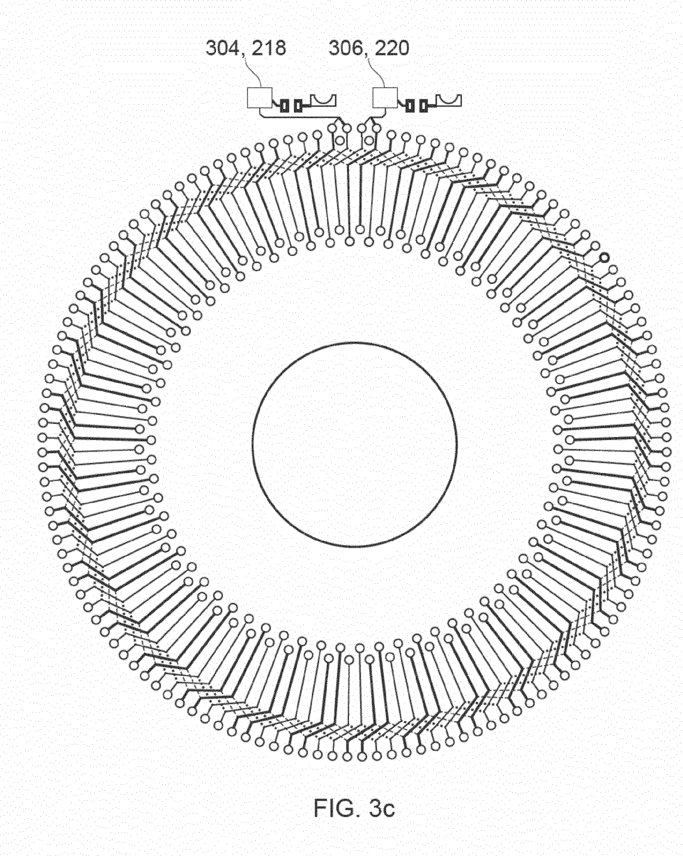

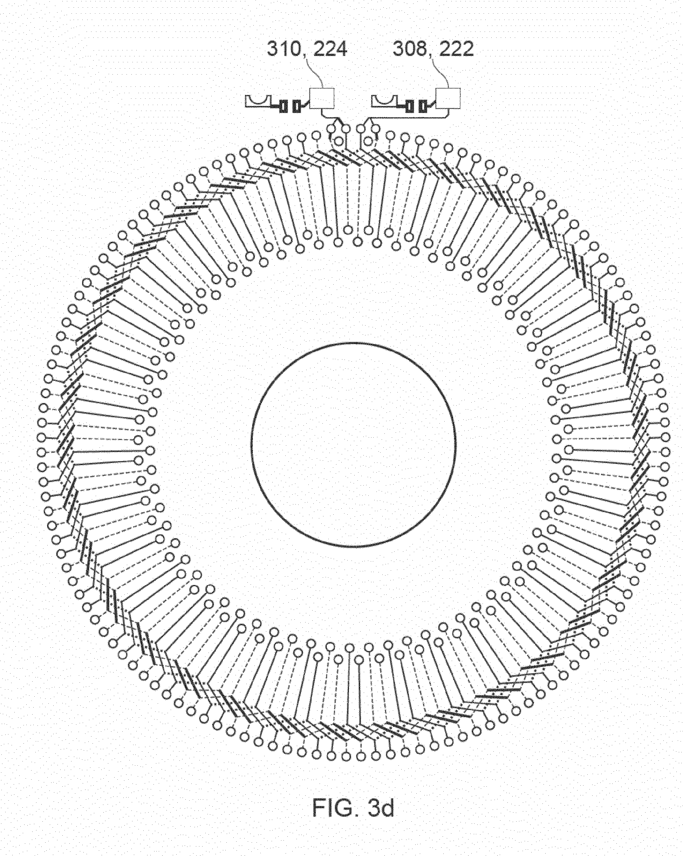

Figure 3c shows a view of the current sensor shown in Figure 2 in a first orientation. As can be seen, the four connections to the measurement coils (first input or positive input 304, 218, second input or negative input 306, 220, a first reference terminal 208, 222 and a second reference terminal 210, 224) are provided using pads or terminals on both sides of the substrate (four pads or terminals in total). Figure 3d shows a view of the current sensor shown in a second or flipped orientation, including the pads or terminals seen from the second side of the substrate.

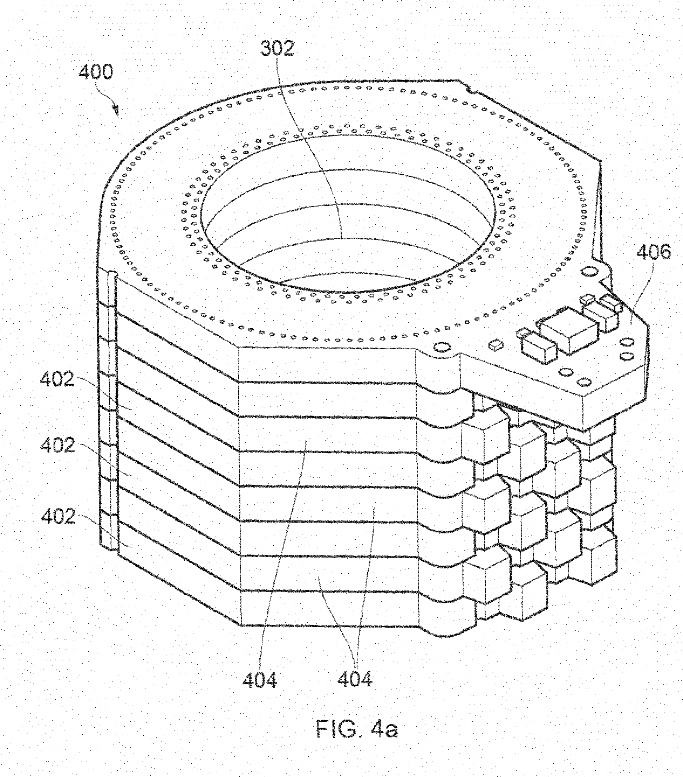

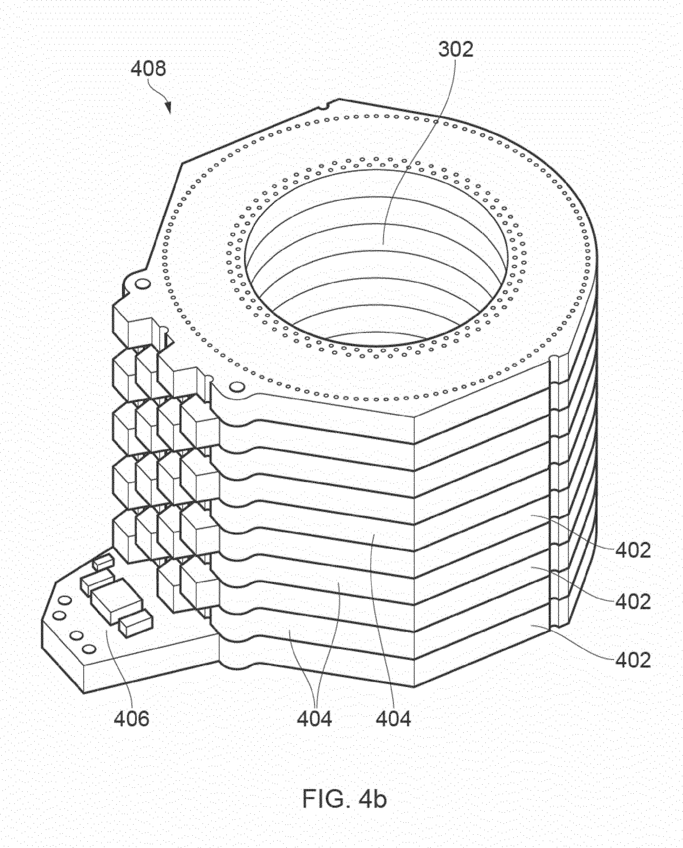

Figures 4a and 4b show stacks or groups of printed circuit boards or substrates. Each of the printed circuit boards or substrates includes two or more current measurement coils surrounding the same path 302 for a current carrying conductor. For example, each of the printed circuit boards or substrates may include four measurement coils as shown in Figure 2c, however alternative numbers of measurement coils may be used. Each of the substrates may be the same as the substrates shown in Figures 3a and 3b. Alternatively, other substrates may be used.

Figure 4a is a current sensor assembly 400 including eight current sensors implemented on circuit boards or substrates 402, 404. One of the substrates of the current sensor 400 shown in Figure 4a includes measurement circuitry 406.

Figure 4b is a current sensor assembly 408 including ten current sensors implemented on printed circuit boards or substrates 402, 404. One of the substrates of the current sensor 408 shown in Figure 4b includes measurement circuitry 406. It should be understood that the number of substrates provided in the current sensors 400, 408 are intended as an example only, and any number of substrates may be stacked or layered in this way. The substrates are stacked, layered or grouped such that they are on top of one another. The substrates are arranged such that they are all substantially centred around a path 302 for a current carrying conductor. Put another way, an axis passing through the centre of each substrate, or through the centre of the path 302, may be the same for all of the substrates within the current sensor.

Alternating substrates in the stacks of substrates are flipped or rotated with respect to an adjacent substrate. For example, where the stack of substrates includes N substrates, numbered from 1-N with respect to the first or last substrate in the stack, each even numbered substrate 404 may be flipped with respect to each odd numbered substrate 402. For example, the even numbered substrates 404 may be provided in the first orientation shown in Figure 3a. The odd numbered substrates 402 may be provided in the second orientation shown in Figure 3b. Where the number of substrates N is a multiple of or divisible by two ensures that the same number of substrates are provided in a first orientation as the number of substrates provided in the second orientation.

Each substrate of the plurality of substrates 402, 404 comprises a first major surface and a second major surface (the flat surfaces of the PCB, through which the vias pass to form the loops of the measurement coils). Put another way, the major surfaces or planes of the substrates are perpendicular to the path 302 for the current carrying conductor. The first orientation comprises the first major surface of the substrates being provided in a first direction. The second orientation comprises the second major surface being provided in the first direction. Put another way, the plurality of substrates are stacked such that the first major surface of each substrate of the plurality of substrates is adjacent to the first major surface of the adjacent substrate of the plurality of substrates.

Each of the substrates 402, 404 is substantially the same, including the same current measurement coils. This stacking arrangement, with adjacent substrates rotated or flipped, results in the measurement coils provided on each substrate of the plurality of substrates having an inverted polarity with regard to its response to the magnetic field created by the conductor in the path 302 compared to the polarity of the measurement coils on an adjacent substrate of the plurality of substrates.

Using common PCB or substrate designs (i.e. all of the substrates comprising the same measurement coil layouts) reduces the manufacturing and design complexity, as a single substrate may be produced a number of times and then stacked in the previously described arrangement.

Whilst the current measurement coils are described as being the same, it should be understood that minor differences may be present between the substrates. For example, there may be differences in the number of turns of each coil, differences in connection apertures or mountings. Optimal performance may be provided when the measurement coils implemented on all of the substrates have the same layout, however minor differences may be acceptable in some situations where performance is less key. Further, one or more of the substrates may include a measurement circuit 406 coupled to the measurement coils. This may be an active or passive measurement circuit 206, which for example, includes one or more of amplification, integration, filtering or buffering components. Further, the layout of the measurement coils on each of the substrates may differ slightly.

Whilst Figures 4a and 4b outline current sensors including 8 and 10 stacked substrates or PCBs respectively, each current sensor may include any number of substrates or PCBs, for example, 2, 4, 6, 8, 10, 12, 14 etc. substrates, with each substrate including two or more measurement coils. The total number of PCBs in each stack may be chosen in dependence on the desired sensitivity of the current sensor, with a greater number of PCBs or substrates used when a greater sensitivity is required. Adding a greater number of PCBs or substrates requires no further computer aided design or alterations to each individual substrate - the design is modular and the total number of PCBs may be adjusted. This allows the system to be modified on-site, with a site engineer determining only the number of substrates required, rather than having to modify the actual design of the current measurement coil included on the substrate.

The current measurement coils included on each of the substrates may be coupled to one another, and coupled to the measurement circuitry such that the signals add constructively, providing an increased signal output compared to a single substrate alone. Whilst the measurement circuitry 406 is shown on one of the substrates in Figures 4a and 4b (a top or bottom substrate respectively), it should be understood that the measurement circuitry 406 may be provided on one of the substrates, distributed across the substrates, or provided as part of an external measurement system that does not form part of the substrates.

To provide electrical insulation between substrates in the stack, protective or insulating films, such as polyimide film cut to the substrate outline shape, could be placed between each board in the stack. Alternatively, the substrates may comprise an insulating layer as an outside layer or surface layer as part of their construction.

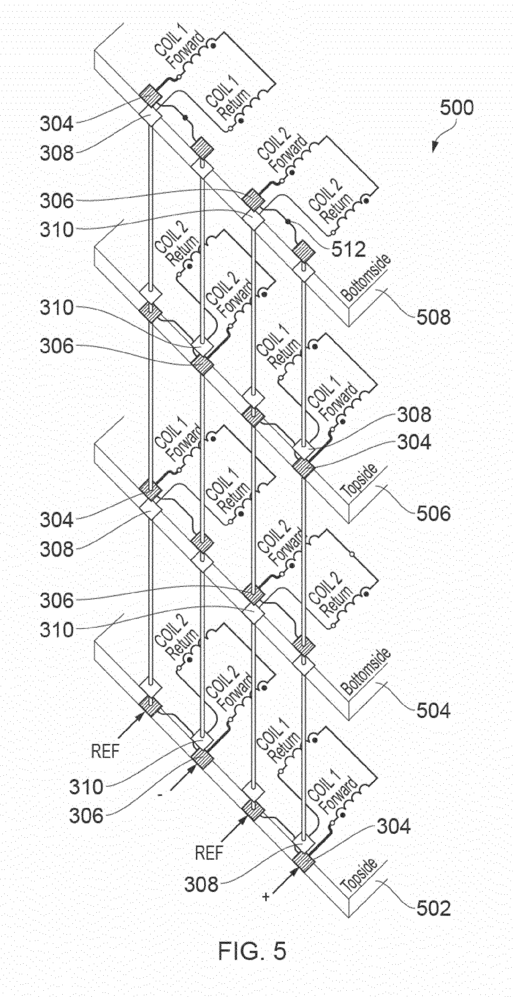

Figure 5 shows an exploded view one example of a stacked current sensor 500 comprising four substrates 502-508. Each of the substrates comprises four measurement coils in the same layout as shown in Figure 2a, 2b and 2c - two forward coils and two return coils. However, the first return coil and second return coil are not coupled to one another on the substrates. Put another way, the third node 222 and fourth node 224 shown in Figure 2c are not coupled together. The measurement coils are shown on the substrates in two separate positions, with the first forward and return coils in one area and the second forward and return coils in a second area, however this is purely for ease of understanding. It should be understood that the measurement coils (forward and return) on each substrate are arranged around a path for a conductor as shown in Figure 2. Further, the four substrates 502-508 are arranged such that all the measurement coils across the four substrates progress around the same path for a conductor.

Every other board in the stack is flipped over. For instance, the vertical stack of four boards would comprise of boards 502, 504, 506, 508 stacked from bottom to top. Boards 502 and 506 (the odd boards) would be facing up or in a first direction, while boards 504 and 508 (even boards) would be facing down or in a second direction. This can be clearly seen from the positioning of the first and second measurement coils on each of the substrates 502-508.

Figure 5 shows the substrates 502-508 separated by gaps for clarity. When connected, the substrates 502-508 may be provided such that they are stacked together with minimal gaps or distances between the substrates as shown in Figure 4. The terminals on each of the substrates are labelled with reference to the particular coil that is coupled to each terminal as described in Figure 3.

Each of the measurement coils included on each substrate is coupled to a terminal 510 at the external edge or circumference of each substrate. These terminals are the same as the first input terminal 304, the second input terminal 306, the third terminal 308 and the fourth terminal 310 shown in Figures 3a and 3b. The coupling between the coils and the terminals creates undesirable loop areas that are susceptible to external, undesired magnetic fields. By mirroring or flipping each alternate substrate, the interference picked up by the loops to the terminals 510 on each odd-numbered board cancel the interference picked up by the loops to the terminals 510 on each even-numbered board. As a result, the odd and even pair of boards together act to positively add the desired electromagnetic field (EMF) from the current carrying conductor while canceling the undesired EMF.

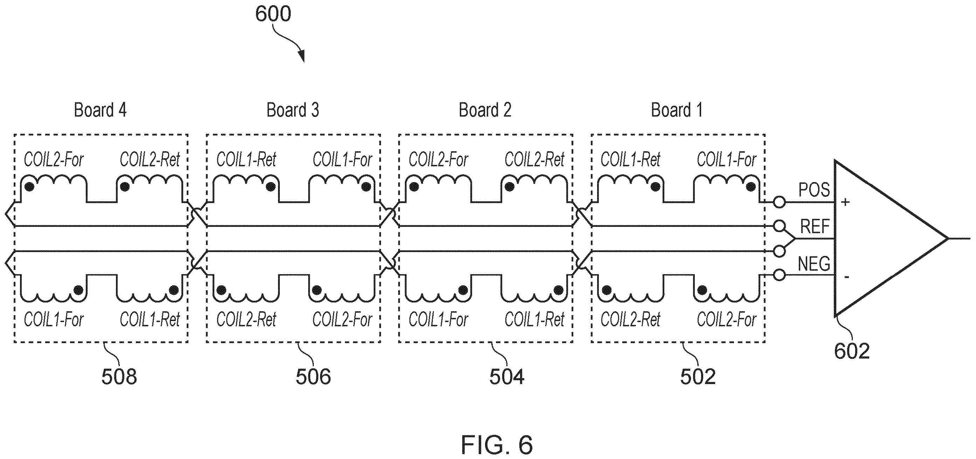

The current measurement coils on the separate substrates are coupled together and output terminals for the complete current sensor stack 500 are provided on substrate 502 (two output terminals - referred to as positive and negative terminals (+ and -) and two reference terminals (REF) suitable for coupling to a common mode of the system. Figure 6 is a schematic diagram showing, in detail, how each of the substrates or boards and measurement coils on each of the substrates 502-508 of Figure 5 are connected.

By flipping or rotating the coil, the polarity of each coil is inverted with respect to its response to the desired magnetic field from the conductor. The dots on the figure indicate the polarity of each of the measurement coils and show how the polarity is switched with each substrate. The connections of each of the coils take this into account to ensure the desired EMF signals are additive.

Figure 6 shows how the respective measurement coils on the four substrates are coupled to one another and to external circuitry such as a differential amplifier 602. It should be understood that the measurement circuit or external circuit 602 may be provided on one of the substrates or separately. The complete routing path starts at the two pins of the differential amplifier - the positive and negative terminals of the external measurement circuit (+ and -). Signal lines are routed from each pin and follow a path through the plurality of substrates of the stack and finally terminate to a common reference point.

The positive input terminal is coupled to the first forward and return measurement coils on the first substrate 502. The first return coil on the first substrate is then coupled to the first forward and return coils on the third substrate 506. The first return coil on the third substrate is then coupled to the second forward and return coils on the fourth substrate 508. The second return coil on the fourth substrate is then coupled to the second forward coil and second return coil on the second substrate 504. The second return coil on the second substrate is then coupled to the reference terminal.

In this way, the measurement coils on the odd substrates are coupled to one another from the first output or positive terminal in a first direction through (in this case up) the stack of substrates. At the top of the stack of substrates, the measurement coils on the third and fourth substrates are coupled to one another, and the measurement coils on the even substrates provide a link in a second direction through (in this case down) the stack of substrates to the reference terminal. This ensures that the positive, negative and reference terminals are all provided adjacent to each other on the same substrate, rather than at opposite ends of the stack of substrates.

The measurement coils coupled to the second or negative output terminal are coupled in a similar manner. The negative input terminal is coupled to the second forward and return measurement coils on the first substrate 502. The second return coil on the first substrate is then coupled to the second forward and return coils on the third substrate 506. The second return coil on the third substrate is then coupled to the first forward and return coils on the fourth substrate 508. The first return coil on the fourth substrate is then coupled to the first forward coil and first return coil on the second substrate 504. The second return coil on the second substrate 504 is then coupled to the reference terminal.

As shown in Figure 5 and described above, the routings or connections between the coils may skip boards using pass-through vias. This allows the connections in a first direction to skip every other substrate, and the connections in the second direction to be made on the remaining substrates. Pass through vias may located on the substrates. These pass-through vias allow measurement coils on non-adjacent substrates to be coupled to one another. For example, a pass-through via is located on the second substrate 504, allowing coupling of the first return measurement coil on the first substrate 502 to the first forward measurement coil on the third substrate.

The positive and negative routes (the connections of coils from each of the positive or first and negative or second terminals) travel along the same path, meaning they should be routed near each other and in the same direction as they route through the stack. This minimizes electrostatic noise coupling. Further, any unintended loop area created from the interconnects may be designed so as to not result in a differential EMF voltage in response to an external magnetic field. This minimizes magnetic noise coupling.

Each substrate shown in figure 5 may include a broken connection between input terminals. This connection may be filled or shorted 512 on the top or end board of the stack of substrates (in this case the fourth substrate 508). This allows the connection between the measurement coils on the top substrate (e.g substrate 508 shown in Figure 6) and the preceding substrate (e.g. substrate 506 shown in Figure 6) to be made. As the broken connection is present on all of the substrates, only a single substrate needs to be manufactured, with the short provided on only one of the substrates using, for example, a short or solder connection added manually.

The substrates 502-508 of Figure 5, and more particularly the measurement coils provided on the substrates, are coupled or connected together using Z-interconnects. A Z-interconnect is where the substrates are bonded together on the surface of each board with some form of conductive material. The terminals 304-310 are provided as conductive pad. To form the connection between substrates, solder may be placed on the surface of terminal pads on each of the substrates 502-508, the boards may be placed one on top of each other and the solder re-flowed to make the connections between the measurement coils on each of the substrates. This allows a simple manufacturing process.

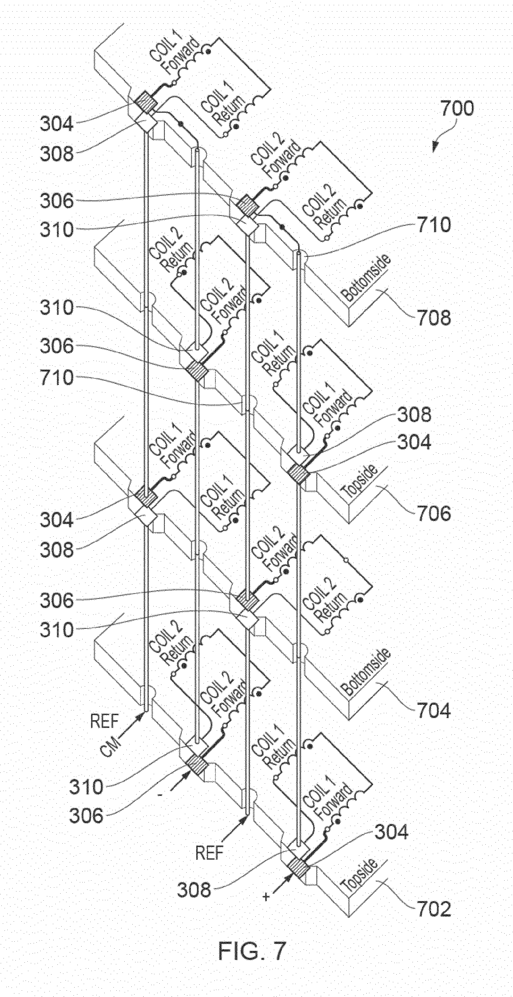

Figure 7 shows an alternative current sensor 700 to the current sensor of Figure 5, in which the substrates and measurement coils are connected in an alternative manner. In the system of Figure 5, measurement coils on non-adjacent substrates are coupled or connected using pass-through vias. The substrates 702-708 include castellated vias or pads 710 on the external circumference of the substrates. The castellated vias 710 may be half-vias which allow conductive wires, solder or segments to be provided through one substrate without providing an electrical connection to that substrate. As such, non-adjacent substrates or current sensors may be coupled to one another through the castellated vias 710, such that terminals or pads on two non-adjacent substrates may be coupled through the castellated via 710 on a substrate located between the two non-adjacent substrates.

The use of castellated vias instead of the previously described Z-interconnects allows simpler manufacture, for example in a lab using hand-soldering. Other connection types between the substrates may be used - Z-interconnects and castellated vias are only two examples.

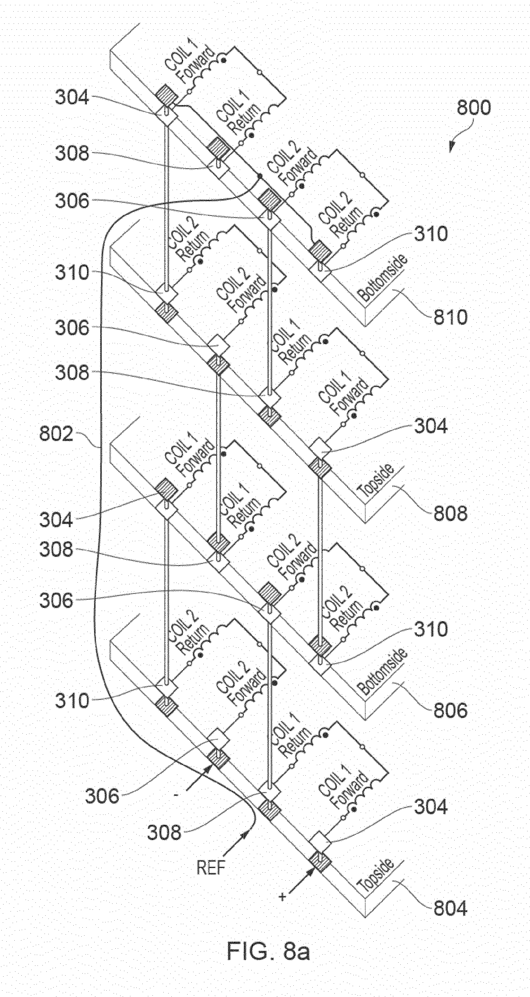

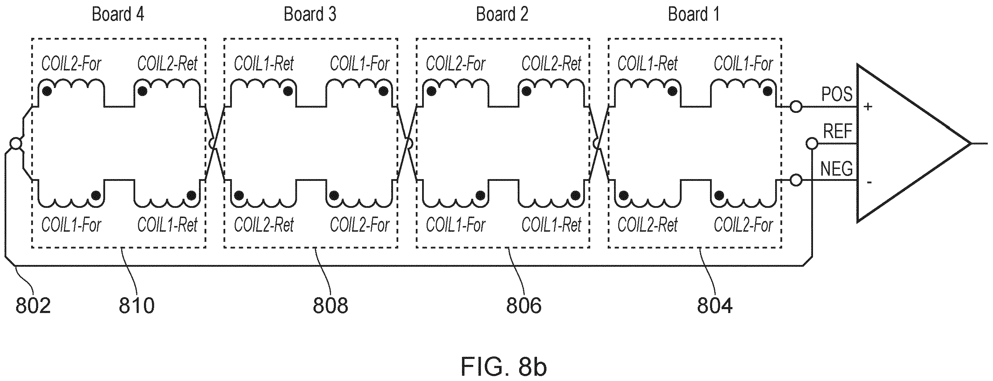

Figure 8a is a diagram of a current sensor 800 including an alternative coupling of the current measurement coils compared to that shown in Figure 5 and Figure 7. The current sensor comprises four substrates 804, 806, 808 and 810. In Figure 5 and 7, the measurement coils on the odd numbered substrates are coupled in one direction and the measurement coils on the even numbered substrates provide a return connection (such that the output terminals are at one end of the stack of substrates). In Figure 8, the measurement coils are coupled in the order of the boards stack, with the positive and negative or first and second measurement coils of each substrate coupled sequentially from one end of the stack of substrates to the other. A single conductor or return 802 is then provided so that the common mode or reference terminal is routed so that it is adjacent to the terminals of the stack of substrates positive and negative connections.

Figure 8b is a schematic diagram showing the coupling of the measurement coils of the current sensor 800 of Figure 8a. The first or positive output terminal is coupled to the first forward and return coils on each of the first 804, second 806, third 808 and fourth 810 substrates sequentially. The second or negative output terminal is coupled to the second forward and return coils on each of the first 804, second 806, third 808 and fourth 810 substrates sequentially. The return conductor provides a routing of the common mode or reference voltage terminal to the fourth substrate 810.

This removes the need to use pass-through vias, as the coils on one substrate are coupled to the coils of an adjacent substrate, however a return or common mode connection is required from one end of the stack of substrates to the other to allow connection to the reference terminal. In Figures 5 and 7, the return connection is provided using the measurement coils themselves.

Figures 2-8 outline a current sensor including four measurement coils per substrate arranged in the manner of Figure 2c (with the notable exception that the return coils on each substrate are not coupled to one another, as they are instead coupled to measurement coils on different substrates). It should be understood that other arrangements of measurement coils on each substrate may be used. For example, any PCB implemented current sensor including two or more measurement coils on each substrate may be implemented using the previously described stacked PCB implementation. Where a single-ended current measurement system is used, each substrate may include a single forward and single return coil, with the coils coupled in the manner of either Figure 6 or Figure 8b. Alternatively, each substrate may include two measurement coils in the same direction (forward or reverse) or in alternate directions (forward and reverse).

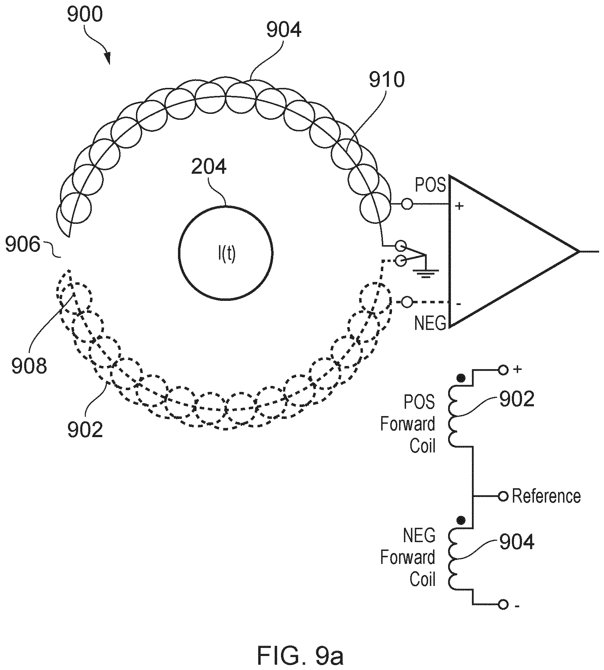

Figure 9a shows an alternative PCB-implemented current measurement coil that may be used. Each substrate includes a first measurement coil 902 and a second measurement coil 904. Each of the measurement coils 902, 904 progress approximately 180 degrees around a path for a current carrying conductor 204. The end of each of the measurement coils 902, 904 is coupled to a respective return conductor 908, 910 which travels in the opposite direction along the circumferential path of the measurement coils. The return conductors 908, 910 provide improved rejection of a magnetic field passing through the face of the PCB by acting as a cancelling loop relative to the loop created by the circumferential progression of the measurement coils. Each substrate includes two half circle measurement coils and two return or reverse conductors.

As the measurement coils are half circles, the output of the current sensor is vulnerable to electrostatic coupling as a result of non-central positioning of the current carrying conductor.

Providing the current measurement coil 900 of Figure 9a in a stacked arrangement, flipping the substrate compared to each adjacent substrate, results in the positive 902 and negative 904 half circle coils alternating sides of the current carrying conductor 204 with each substrate. For example, on a first substrate, the first measurement coil 902 is on a first side of the conductor 204, whilst on the second flipped substrate, the first measurement coil 902 is on a second side of the conductor 204. This reduces the sensitivity to changes in the positioning of the conductor.

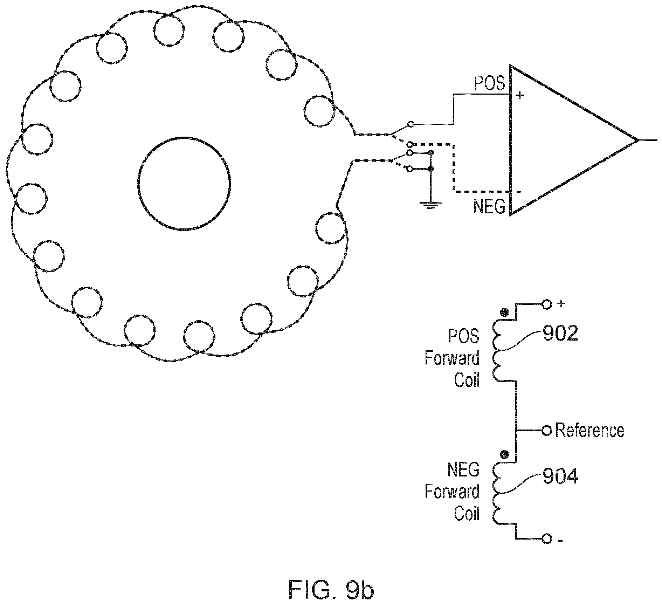

Figure 9b shows an alternative PCB-implemented current measurement coil that may be used in a stacked current sensor. Each substrate includes a first measurement coil 908 and a second measurement coil 910. This alternative PCB-implemented current sensor has no return wire nor return coil, and thus can produce a large common mode voltage when exposed to an external magnetic field into the face of the PCB. By flipping alternate boards, for example flipping each odd board, the common mode voltage of the even board can be cancelled by the common mode voltage of the odd board.

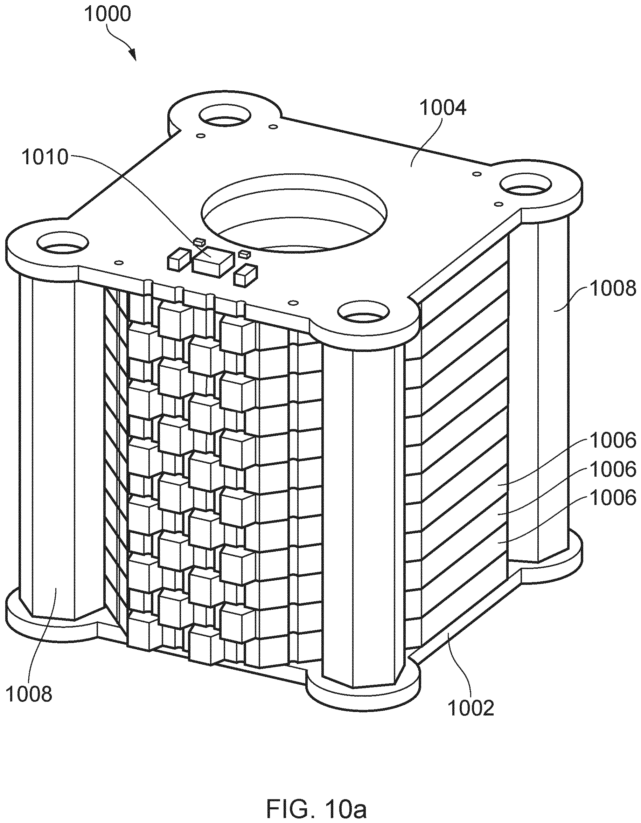

Figure 10a shows a current sensor system 1000 or mounting system for a current sensor. The current sensors described with respect to any of the preceding Figures may be mounted in the mounting system shown in Figure 10a. The system 1000 includes a first support substrate 1002 and a second support substrate 1004. The first support substrate 1002 and the second support substrate 1004 are coupled to one another using a plurality of mechanical support 1008 or mechanical support elemented. The plurality of mechanical support elements 1008 may be columns or other supporting structures that couple the corners of the support substrates 1002, 1004 to one another. The mechanical supports 1008 may also be coupled to other positions on the substrates. The current sensor assembly described previously may be stacked or positioned in-between the first support substrate 1002 and the second support substrate 1004.

The first support substrate 1002 and second support substrate 1004 act to sandwich, hold-together, support or frame the plurality of substrates 1006 that form the stacked current sensor. The plurality of substrates comprising measurement coils are stacked as described previously, and then placed between the support substrates 1002, 1004. In this way, the plurality of substrates 1006 are held together in a stack. Both the support substrates 1002, 1004 and the mechanical support elements 1008 act to support the substrates.

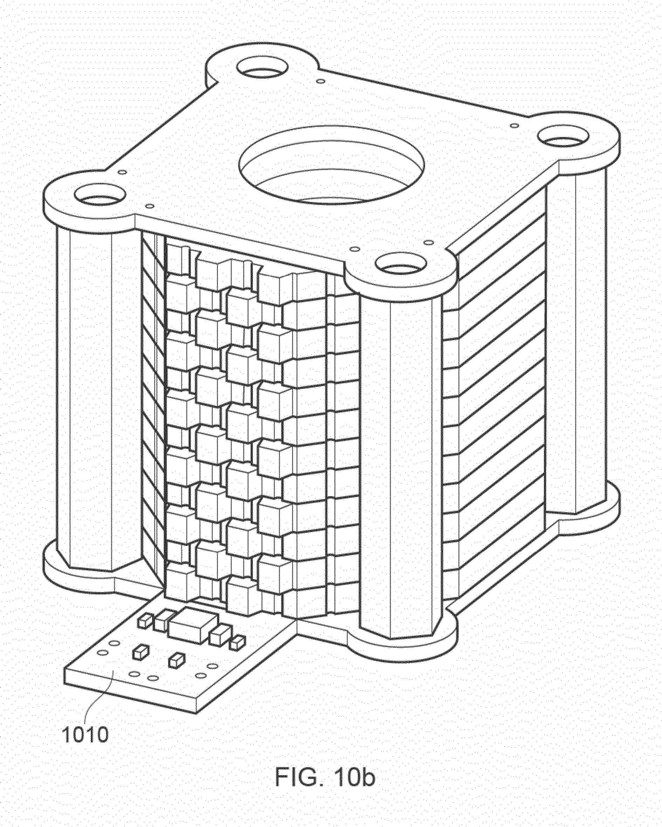

The support substrates 1004 may be further PCBs that include current measurement coils that form part of the stack. As shown in both Figure 10a and Figure 10b, additionally or alternatively, the support substrates 1004 may comprise measurement electronics 1010 to determine the current through the conductor under measurement, or electronics 1010 that form part of a wider utility meter or power meter. The support substrates may comprise electrostatic shielding, for example a ground plane to reduce noise coupling into the current measurement system.

Each individual PCB included within the stack may be edge-plated to provide shielding and contain additional shielding vias or shielding copper layers if used in a location where high voltages could electrostatically couple to the PCB di/dt sensor. This shields the sensor and current measurement coils located within the shield. Edge plating may be shielding along non-major surfaces of the substrates.

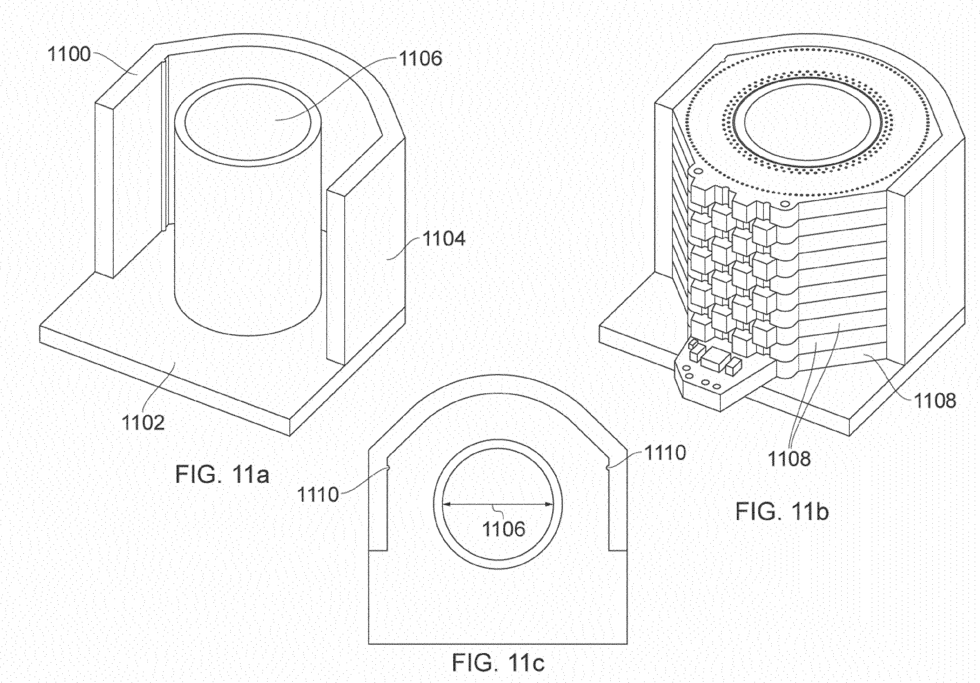

Figure 11a shows a frame or jig 1100 for supporting or mounting the plurality of substrates that form the current sensor. The frame 1100 comprises a base 1102, an outer wall 1104 and a central tube or protrusion 1106. The central or middle tube or protrusion 1106 is suitable for receiving a current carrying conductor or conductor under measurement. The frame 1100 is configured for holding the stacked plurality of current sensors 1108 such that each of the current sensors is held in a fixed position relative to the other current sensors of the stacked plurality of current sensors. This may be achieved in a number of different ways.

As shown in Figure 11b, the plurality of substrates 1108 may be stacked on the frame 1100. The plurality of substrates include apertures or paths for a current carrying conductor that fit around the central tube or protrusion 1106 of the frame 1100. The central tube or protrusion 1106 may be substantially the same shape as the path 302 for the conductor in the substrates comprising the measurement coils. The outer wall 1104 may be shaped so as to surround the substrates 1108. Put another way, the centre or middle tube or protrusion 1106 has a cross-sectional profile which matches at least part of the cross-sectional profile of the each of the current sensors 1108. This allows the current sensors 1108 to be slotted onto or stacked onto the frame 1100. The same is true for the outer wall 1104, which has a cross-sectional shape matched to at least part of the outer perimeter of each of the current sensors 1108.

The outer wall 1104 of the frame 1100 may comprise one or more groove, projection or channel 1110. The plurality of substrates 1108 may include external projections, grooves or channels on one or more sides arranged to fit within the grooves, projections or channels of the outer wall 1104. This secures the substrates 1108 to the outer wall 1104 and ensures that the substrates are provided on the frame in the correct orientation. Any suitable engagement portion may be provided on the frame 1100 and the current sensors 1108, such that the engagement portion on the frame 1100 corresponds to, or is configured to engage with, the engagement portion on each current sensor 1108.

The frame 1100 shown in Figure 11 may be used to support the plurality of PCBs or substrates in place. Alternatively, the frame 1100 may be a jig used during assembly which is removed after assembly (once the PCBs have been coupled or connected to one another, for example by soldering).

The frame or jig 1100 may be used as a protective housing following manufacture and removed prior to the installation of the current sensor in place. The frame 1100 could also incorporate other features such as mounting holes or flanges, clips, cable directing and retaining features, electrical shielding, electrical isolation, etc.

A layer of soft material such as foam could also be inserted between the PCBs and frame or jig 1100, to cushion the current sensor from mechanical shock.

The current sensor, including the plurality of PCBs or substrates, and any cabling could also be potted, included within or surrounded by a protective material, e.g. epoxy resin or silicone. This protective material may be provided within a sealed version of the frame or jig 1100. The protective material may provide weatherproofing for use outdoors or in harsh environments.

Whilst the preceding description describes current sensors made up of a plurality of substrates or PCBs, each including a plurality of measurement coils, it should be understood that the design could be embedded in a larger single PCB structure having a high layer count. This may be achieved either with a large multilayer design, or using other advanced PCB fabrication technologies, e.g. high density interconnect (HDI) or Z-connect technology to create what is effectively one large PCB.

The signal amplitude generated by the measurement coils is effectively doubled with each extra substrate used. This increased sensitivity allows smaller currents to be accurately measured. Coupling the measurement coils of a plurality of substrates in series increases the series impedance of the system, however this may be compensated for in the processing electronics. For example, a temperature correction coefficient factor may be implemented in the processing electronics to make the electronics track the changing temperature due to the increased series resistance.

Various modifications whether by way of addition, deletion, or substitution of features may be made to the above described examples to provide further examples, any and all of which are intended to be encompassed by the appended aspects.

Aspects of the disclosure:
1. A current sensor, the current sensor comprising:
   a plurality of substrates, wherein each substrate of the plurality of substrates comprises:
      a path for a current carrying conductor;
      a plurality of measurement coils progressing in a circumferential direction around the path for the current carrying conductor;
   wherein the plurality of substrates are stacked such that each substrate of the plurality of substrates is rotated with respect to an adjacent substrate of the plurality of substrates.
2. The current sensor according to aspect 1, wherein the plurality of substrates comprises one or more even-numbered substrates and one or more odd-numbered substrates.
3. The current sensor according to aspect 2, wherein the plurality of substrates are stacked such that each even-numbered substrate is stacked next to an odd-numbered substrate.
4. The current sensor according to aspect 2 or aspect 3, wherein the even-numbered substrates are stacked in a first orientation and wherein the odd-numbered substrates are stacked in a second orientation.
5. The current sensor according to aspects 4, wherein each substrate of the plurality of substrates comprises a first major surface and a second major surface, and wherein the first orientation comprises the first major surface of the substrate being provided in a first direction and wherein the second orientation comprises the second major surface of the substrates being provided in the first direction.
6. The current sensor according aspect 1, wherein each substrate of the plurality of substrates comprises a first major surface and a second major surface, and wherein the plurality of substrates are stacked such that the first major surface of each substrate of the plurality of substrates is adjacent to the first major surface of the adjacent substrate of the plurality of substrates.
7. The current sensor according to any preceding aspect, wherein the plurality of substrates are stacked such that the plurality of measurement coils of each substrate of the plurality of substrates has an inverted polarity in regard to its response to the magnetic field created by the conductor with respect to the plurality of measurement coils of an adjacent substrate of the plurality of substrates.
8. The current sensor according to any preceding aspect, wherein the plurality of measurement coils on the one or more even-numbered substrates are coupled to the plurality of measurement coils on the one or more even-numbered substrates.
9. The current sensor according to any preceding aspect, wherein the plurality of measurement coils on the one or more odd-numbered substrates are coupled to the plurality of measurement coils on the one or more odd-numbered substrates.
10. The current sensor according to any preceding aspect, wherein the plurality of measurement coils are coupled to one another using Z-interconnects.
11. The current sensor according to any of aspects 1-8, wherein the plurality of substrates comprise castellated vias on an external circumference of the plurality of substrates, and wherein the plurality of measurement coils are coupled to one another using connections between the castellated vias.
12. The current sensor according to any preceding aspect, wherein the plurality of measurement coils of the plurality of substrates are of the same design.
13. The current sensor according to any preceding aspect, wherein the plurality of measurement coils progress in the same manner in the circumferential direction around the path for the current carrying conductor on each of the plurality of substrates.
14. The current sensor according to any preceding aspect, wherein one of the plurality of substrates further comprises a measurement circuit coupled to the plurality of measurement coils.
15. The current sensor according to any preceding aspect, wherein the current sensor further comprises:
   a further substrate upon which the plurality of substrates are mounted, the further substrate comprising a measurement circuit coupled to the plurality of measurement coils.
16. The current sensor according to any preceding aspect, further comprising:
   a first support substrate;
   a second support substate;
   a plurality of mechanical supports coupling the first support substrate and the second support substate, wherein the plurality of substrates are stacked in-between the first support substrate and the second support substrate.
17. The current sensor according to aspect 16, further comprising a measurement circuit on at least one of the first support substrate and the second support substrate.
18. The current sensor according to any preceding aspect, further comprising:
   a frame, the frame comprising:
   one or more grooves, slots or holes arranged to interface with the plurality of substrates such that the plurality of substrates stack on the frame.

A second set of aspects of the disclosure is provided below:
1. A current sensor assembly comprising:
   a stacked plurality of current sensors, each of the plurality of current sensors comprising:
      a substrate;
      a path for a conductor carrying current; and
      a plurality of measurement coils each arranged to progress at least partially around the path for the conductor,
   wherein the plurality of current sensors are stacked such that, in use, a first signal induced in a first current sensor of the plurality of current sensors by a current in the conductor has a different polarity to a second signal induced in a second current sensor of the plurality of current sensors by the current in the conductor.
2. The current sensor assembly according to Aspect 1, wherein the first current sensor and the second current sensor are adjacent in the stacked plurality of current sensors.
3. The current sensor assembly according to any preceding Aspect, wherein the first current sensor and the second current sensor of the plurality of current sensors have different relative orientations such that, in use, the first signal has a different polarity to the second signal.
4. The current sensor assembly according to any preceding Aspect, wherein the stacked plurality of current sensors further comprises a third current sensor arranged, such that, in use, a third signal induced in the third current sensor by the current the conductor has the same polarity as the signal induced in the first current sensor.
5. The current sensor assembly according to Aspect 4, wherein the second current sensor is positioned between the first current sensor and the third current sensor in the stack.
6. The current sensor assembly according to Aspect 5, wherein the first current sensor is electrically coupled to the third sensor.
7. The current sensor assembly according to Aspect 5, wherein the first current sensor is electrically coupled to the second current sensor.
8. The current sensor assembly according to Aspect 7, wherein the second current sensor is electrically coupled to the third current sensor.
9. The current sensor assembly according to any preceding Aspect, wherein the substrate of each of the plurality of current sensors comprises a first surface and a second, opposing surface.
10. The current sensor assembly according to Aspect 9, wherein the first current sensor is oriented such that its first surface faces a first direction in the stack and its second surface faces a second direction in the stack, and the second sensor is oriented such that its first surface faces the second direction in the stack and its second surface faces the first direction in the stack, wherein the first direction is opposite to the second direction.
11. The current sensor assembly according to any preceding Aspect, wherein each of the plurality of current sensors are substantially identical in design.
12. The current sensor assembly according to any preceding Aspect, wherein a layout of the plurality of measurement coils on each substrate of the plurality of substrates is substantially the same.
13. The current sensor assembly according to any preceding Aspect, wherein at least one substrate of the plurality of substrates comprises measurement circuitry coupled to the plurality of measurement coils on that substrate.
14. The current sensor assembly according to any preceding Aspect, wherein at least one measurement coil of the plurality of measurement coils on each of the current sensors of the plurality of current sensors is coupled to at least one measurement coil of the plurality of measurement coils on at least one other current sensor of the plurality of current sensors.
15. The current sensor assembly according to any preceding Aspect, wherein each current sensor of the plurality of current sensors is electrically coupled at least one other current sensor of the plurality of current sensors using at least one Z-interconnect.
16. The current sensor assembly according to any preceding Aspect, wherein each substrate of the plurality of current sensors comprises castellated vias on an external circumference of the substrate.
17. The current sensor assembly according to Aspect 16, wherein each current sensor of the plurality of current sensors is coupled to at least one other current sensor of the plurality of current sensors using the castellated vias.
18. The current sensor assembly according to any preceding Aspect, wherein the current sensor further comprises:
   a first support substrate upon which the plurality of current sensors are stacked.
19. The current sensor assembly according to Aspect 18, further comprising:
   a second support substate; and
   a plurality of mechanical supports coupling the first support substrate and the second support substate, wherein the stacked plurality of current sensors are positioned between the first support substrate and the second support substrate.
20. The current sensor assembly according to Aspect 19, further comprising a measurement circuit on at least one of the first support substrate and the second support substrate.
21. The current sensor assembly according to any preceding Aspect, further comprising:
   a frame arranged to hold the stacked plurality of current sensors such that each of the current sensors is held in a fixed position relative to the other current sensors of the stacked plurality of current sensors.
22. The current sensor assembly according to Aspect 21, wherein the frame comprises at least one engagement portion configured to engage with at least one corresponding engagement portion on each of the stacked plurality of current sensors, so as to hold each of the current sensors of the plurality of current sensors in a fixed position relative to the frame and the other current sensors of the plurality of current sensors.
23. The current sensor assembly according to Aspect 21 or 22, wherein at least part of the cross-sectional profile of each of the stacked plurality of current sensors matches at least part of the cross-sectional profile of the frame.
24. The current sensor assembly according to any preceding Aspect, wherein the current sensor assembly comprises a differential output, and wherein the current sensors are electrically coupled such that:
   the first signal induced in the first current sensor by the current in the conductor is additively combined at the differential output with the second signal induced in the second current sensor by the current in the conductor.
25. The current sensor assembly according to any Aspect 24, wherein the current sensors are electrically coupled such that:
   a first noise signal induced in the first current sensor by a noise source is destructively combined at the differential output with a second noise signal induced in the second current sensor by the noise source.
26. A current measurement system, the current measurement system comprising: a current sensor assembly comprising:
   a stacked plurality of current sensors, each of the plurality of current sensors comprising:
   a substrate;
   a path for a conductor carrying current; and
   a plurality of measurement coils each arranged to progress at least partially around the path for the conductor,
   wherein the plurality of current sensors are stacked such that, in use, a first signal induced in a first current sensor of the plurality of current sensors by a current in the conductor has a different polarity to a second signal induced in a second current sensor of the plurality of current sensors by the current in the conductor;
   a measurement circuit coupled to the current sensor assembly, the measurement circuit configured to receive an output of the current sensor assembly and determine a current in the conductor.
27. A current sensor assembly comprising:
   a stacked plurality of current sensors, each of the plurality of current sensors comprising:
      a substrate;
      a path for a conductor carrying current; and
      a plurality of measurement coils each arranged to progress at least partially around the path for the conductor,
   wherein each of the plurality of current sensors are substantially identical in design, and each of the plurality of current sensors comprise a first surface and a second surface,
   wherein a first group of current sensors of the plurality of current sensors are oriented in the stack such that the first surface of each of the first group of current sensors is oriented in a first direction,
   wherein a second group of current sensors of the plurality of current sensors are oriented in the stack such that the first surface of each of the second group of current sensors is oriented in a second direction, the second direction being opposite to the first direction.
28. The current sensor assembly according to Aspect 27, wherein each of the first group of current sensors is provided such that it is adjacent in the stack to a current sensor of the second group of current sensors.

## Claims

1. A current sensor assembly comprising:
a stacked plurality of current sensors, each of the plurality of current sensors comprising:
a substrate;
a path for a conductor carrying current; and
a plurality of measurement coils each arranged to progress at least partially around the path for the conductor,
wherein the plurality of current sensors are stacked such that, in use, a first signal induced in a first current sensor of the plurality of current sensors by a current in the conductor has a different polarity to a second signal induced in a second current sensor of the plurality of current sensors by the current in the conductor.

2. The current sensor assembly according to claim 1, wherein the first current sensor and the second current sensor are adjacent in the stacked plurality of current sensors.

3. The current sensor assembly according to any preceding claim, wherein the first current sensor and the second current sensor of the plurality of current sensors have different relative orientations such that, in use, the first signal has a different polarity to the second signal.

4. The current sensor assembly according to any preceding claim, wherein the stacked plurality of current sensors further comprises a third current sensor arranged, such that, in use, a third signal induced in the third current sensor by the current in the conductor has the same polarity as the first signal induced in the first current sensor.

5. The current sensor assembly according to claim 4, wherein the second current sensor is positioned between the first current sensor and the third current sensor in the stack.

6. The current sensor assembly according to claim 5, wherein:
the first current sensor is electrically coupled to the third current sensor; or
the first current sensor is electrically coupled to the second current sensor and optionally wherein the second current sensor is electrically coupled to the third current sensor.

7. The current sensor assembly according to any preceding claim, wherein the substrate of each of the plurality of current sensors comprises a first surface and a second, opposing surface, and wherein the first current sensor is oriented such that its first surface faces a first direction in the stack and its second surface faces a second direction in the stack, and the second sensor is oriented such that its first surface faces the second direction in the stack and its second surface faces the first direction in the stack, wherein the first direction is opposite to the second direction.

8. The current sensor assembly according to any preceding claim, wherein each of the plurality of current sensors are substantially identical in design.

9. The current sensor assembly according to any preceding claim, wherein at least one measurement coil of the plurality of measurement coils on each of the current sensors of the plurality of current sensors is coupled to at least one measurement coil of the plurality of measurement coils on at least one other current sensor of the plurality of current sensors.

10. The current sensor assembly according to any preceding claim, wherein each current sensor of the plurality of current sensors is electrically coupled at least one other current sensor of the plurality of current sensors using at least one Z-interconnect.

11. The current sensor assembly according to any preceding claim, wherein each substrate of the plurality of current sensors comprises castellated vias on an external circumference of the substrate.

12. The current sensor assembly according to any preceding claim, wherein the current sensor further comprises:
a first support substrate upon which the plurality of current sensors are stacked;
a second support substate; and
a plurality of mechanical supports coupling the first support substrate and the second support substate, wherein the stacked plurality of current sensors are positioned between the first support substrate and the second support substrate.

13. The current sensor assembly according to any preceding claim, further comprising:
a frame arranged to hold the stacked plurality of current sensors such that each of the current sensors is held in a fixed position relative to the other current sensors of the stacked plurality of current sensors.

14. A current measurement system, the current measurement system comprising:
the current sensor assembly according to any preceding claim; a measurement circuit coupled to the current sensor assembly, the measurement circuit configured to receive an output of the current sensor assembly and determine a current in the conductor.

15. A current sensor assembly comprising:
a stacked plurality of current sensors, each of the plurality of current sensors comprising:
a substrate;
a path for a conductor carrying current; and
a plurality of measurement coils each arranged to progress at least partially around the path for the conductor,
wherein each of the plurality of current sensors are substantially identical in design, and each of the plurality of current sensors comprise a first surface and a second surface,
wherein a first group of current sensors of the plurality of current sensors are oriented in the stack such that the first surface of each of the first group of current sensors is oriented in a first direction,
wherein a second group of current sensors of the plurality of current sensors are oriented in the stack such that the first surface of each of the second group of current sensors is oriented in a second direction, the second direction being opposite to the first direction.
